# EUROPÄISCHE PATENTSCHRIFT

(11) **EP 1 982 415 B1**
(45) Veröffentlichungstag und Bekanntmachung des Hinweises auf die Patenterteilung: **26.10.2011**
(21) Anmeldenummer: 07846813.9
(22) Anmeldetag: 26.11.2007
(51) Int. Cl.: H03K 17/00, H03K 19/173, H04L 25/02

(54) **INTEGRIERTER TREIBERSCHALTKREIS FÜR EINEN LIN-BUS**
INTEGRATED DRIVER CIRCUIT FOR AN LIN BUS
CIRCUIT PILOTE INTÉGRÉ POUR BUS LIN

(30) Priorität: 29.11.2006 DE 102006058184
(43) Veröffentlichungstag der Anmeldung: 22.10.2008
(73) Patentinhaber: Atmel Automotive GmbH, 74072 Heilbronn (DE)
(72) Erfinder: PANNWITZ, Axel, 01445 Radebeul (DE)
(74) Vertreter: Grünecker, Kinkeldey, Stockmair & Schwanhäusser
(86) Internationale Anmeldenummer: PCT/EP2007/010243
(87) Internationale Veröffentlichungsnummer: WO 2008/064844

(56) Entgegenhaltungen:
- US-A1- 2006 261 856
- PHILIPS SEMICONDUCTORS: "Product Specification TJA1020 LIN TRANSCEIVER" INTEGRATED CIRCUITS DATA SHEET, [Online] 13. Januar 2004 (2004-01-13), Seiten 1-22, XP002472295 Gefunden im Internet: URL:http://www.nxp.com/acrobat_download/da tasheets/TJA1020_5.pdf> [gefunden am 2008-03-11]
- ELMENREICH W ET AL: "A Comparison of Fieldbus Protocols: LIN 1.3, LIN 2.0, and TTP/A" EMERGING TECHNOLOGIES AND FACTORY AUTOMATION, 2005. ETFA 2005. 10TH IEEE CONFERENCE ON CATANIA, ITALY 19-22 SEPT. 2005, PISCATAWAY, NJ, USA,IEEE, 19. September 2005 (2005-09-19), Seiten 747-753, XP010905405 ISBN: 0-7803-9401-1
- SPECKS J: "LIN - Protocol, development tolls, and software interfaces for local interconnect networks in vehicles. - Lin - Protokoll, entwicklungswerkzeuge und software-schnittstell fuer lokale datennetzwerke in kraftfahrzeug" INTERNATIONAL CONFERENCE ON ELECTRONIC SYSTEMS FOR VEHICLES, XX, XX, 5. Oktober 2000 (2000-10-05), Seiten 1-24, XP002287370

## Beschreibung

Die Erfindung betrifft einen integrierten Treiberschaltkreis für einen Local-Interconnect-Network(LIN)-Bus.

Derartige Treiberschaltkreise werden auch als LIN-Bustreiber oder LIN-Transceiver bezeichnet. Bei dem integrierten Treiberschaltkreis wird an einen Eingangsanschluss ein Eingabedatensignal angelegt, das beispielsweise von einem Mikrocontroller bereitgestellt wird, der Daten über den LIN-Bus übertragen will. An einem Ausgangsanschluss des integrierten Treiberschaltkreises, der mit einer Busleitung des LIN-Bus verbunden ist, wird ein von dem Eingangsdatensignal abhängiges Ausgangsdatensignal ausgegeben, welches Spannungspegel, Flankensteilheiten usw. gemäß einer LIN-Spezifikation oder eines LIN-Standards erfültt.

Derzeit existieren für LIN-Bustreiber zwei gebräuchliche Spezifikationen (Standards, Normen). Die ältere der beiden Spezifikationen, welche die Versionsnummer V1.3 trägt, weist langsamere Signalflanken auf als die neuere der beiden Versionen, welche die Versionsnummer V2.0 trägt. Derzeit werden beide Versionen am Markt nachgefragt.

Herkömmliche Treiber unterstützen entweder die erste Version V 1.3 oder die zweite Version V2.0 mit schnelleren Flanken. Bei der Herstellung integrierter Treiberschaltkreise ist es daher notwendig, für jede Version einen versionsspezifischen Treiberschaltkreis zu implementieren.

Aus der Druckschrift Philips Semiconductors: "Product Specification TJA1020 LIN Transceiver" Integrated Circuits Data Sheet, [Online] 13. Januar 2004, Seiten 1-22, unter URL:http://www.nxp.com/acrobat_downtoad/datasheets/TJA1020_5. pdf ist eine LIN Tranceiver bekannt , der an einem einzigen Dateneingag unterschiedliche schnell ansteigende Datensignale erkennt.

Der Erfindung liegt die Aufgabe zugrunde, einen integrierten Treiberschaltkreis für einen LIN-Bus zur Verfügung zu stellen, der in einfacher Weise zwischen einer ersten und mindestens einer zweiten Spezifikation umschaltbar ist, so dass insbesondere bei der Herstellung des integrierten Treiberschaltkreises keine versionsspezifische Unterscheidung zu treffen ist, bzw. diese erst in einem möglichst späten Herstellungsschritt zu treffen ist.

Die Erfindung löst die Aufgabe durch einen integrierten Treiberschaltkreis für einen LIN-Bus mit den Merkmalen des Anspruchs 1.

Der integrierte Treiberschaltkreis für einen LIN-Bus umfasst einen ersten Eingangsanschluss, an den ein Eingangsdatensignal anlegbar ist, einen Ausgangsanschluss, der mit einer Busleitung des LIN-Bus zu verbinden ist und an dem ein von dem Eingangsdatensignal abhängiges Ausgangsdatensignal ausgegeben wird, mindestens einen zweiten Eingangsanschluss, wobei das Eingangsdatensignal entweder an den ersten Eingangsanschluss oder den zweiten Eingangsanschluss anzulegen ist, eine Sendeschaltung, die zwischen den Ausgangsanschtuss und den ersten und den zweiten Eingangsanschluss eingeschleift ist und die aus dem Eingangsdatensignal das Ausgangsdatensignal erzeugt, wobei die Sendeschaltung in Abhängigkeit von einem Spezifikationsauswahlsignal das Ausgangsdatensignal gemäß einer ersten Spezifikation (Standard, Norm) oder gemäß mindestens einer zweiten Spezifikation (Standard, Norm) erzeugt, und eine mit dem ersten und dem zweiten Eingangsanschluss und der Sendeschaltung gekoppelte Spezifikationsauswahlschaltung, die das Spezifikationsauswahlsignal in Abhängigkeit davon erzeugt, ob das Eingangsdatensignal an den ersten Eingangsanschluss oder den mindestens zweiten Eingangsanschluss angelegt ist. Der integrierte Treiberschaltkreis kann daher Ausgangsdatensignale gemäß der ersten Spezifikation und der mindestens zweiten Spezifikation senden (ein Datenempfang über den LIN-Bus kann in herkömmlicher Weise erfolgen), wobei ein Umschalten zwischen den unterschiedlichen Spezifikationen in einfacher Weise in Abhängigkeit davon erfolgt, ob das Eingangsdatensignal an den ersten Eingangsanschluss oder den mindestens zweiten Eingangsanschluss angelegt ist.

In einer Weiterbildung des integrierten Treiberschaltkreises weisen Ausgangsdatensignale, die gemäß der ersten Spezifikation erzeugt werden, eine andere Flankensteilheit auf als Ausgangsdatensignale, die gemäß der zweiten Spezifikation erzeugt werden. Ein weiteres Unterscheidungsmerkmal zwischen den unterschiedlichen Spezifikationen kann auch ein maximaler Strom (Kurzschlussstrom) des integrierten Treiberschaltkreises sein.

In einer Weiterbildung des integrierten Treiberschaltkreises ist die erste Spezifikation die LIN-Bus-Spezifikation Version 1.3 und die zweite Spezifikation ist die LIN-Bus-Spezifikation Version 2.0. Es versteht sich, dass auch zukünftige LIN-Bus-Spezifikationen mit umfasst sind.

In einer Weiterbildung des integrierten Treiberschaltkreises umfasst die Spezifikationsauswahlschaltung ein Flip-Flop, wobei ein erster Flip-Flop-Eingangsanschluss mit dem ersten Eingangsanschluss verbunden ist, ein zweiter Flip-Flop-Eingangsanschluss mit dem zweiten Eingangsanschluss verbunden ist und an einem Flip-Flop-Ausgangsanschluss das Spezifikationsauswahlsignal ansteht. Auf diese Weise kann die Spezifikationsauswahlschaltung mittels eines Standardbauelements implementiert werden.

In einer Weiterbildung des integrierten Treiberschaltkreises ist zwischen den ersten Eingangsanschluss und eine Versorgungsspannung ein erster Pull-Up-Widerstand eingeschleift und zwischen den zweiten Eingangsanschluss und die Versorgungsspannung ist ein zweiter Pull-Up-Widerstand eingeschleift. Mittels der Pull-Up-Widerstände wird der nicht benutzte Eingangsanschluss statisch auf einem definierten High-Pegel gehalten.

In einer Weiterbildung des integrierten Treiberschaltkreises ist zwischen die Sendeschaltung und den ersten und zweiten Eingangsanschluss ein UND-Gatter eingeschleift, wobei ein erster UND-Gatter-Eingangsanschluss mit dem ersten Eingangsanschluss verbunden ist, ein zweiter UND-Gatter-Eingangsanschluss mit dem zweiten Eingangsanschluss verbunden ist und ein UND-Gatter-Ausgangsanschluss mit der Sendeschaltung verbunden ist. Wenn der nicht mit Eingangsdatensignal beaufschlagte Eingangsanschluss als Eingangssignal des UND-Gatters statisch eine logische "1" liefert, wird am Ausgang des UND-Gatters das Eingangsdatensignal ausgegeben.

In einer Weiterbildung des integrierten Treiberschaltkreises ist der erste Eingangsanschluss als ein erster Bond-Pad ausgeführt und der zweite Eingangsanschluss ist als ein zweiter Bond-Pad ausgeführt, wobei bei einem Verpackungs- oder Bondvorgang des integrierten Treiberschaltkreises in Abhängigkeit von einer gewünschten Spezifikation entweder der erste Bond-Pad oder der zweite Bond-Pad mit einem zugehörigen Eingangsanschluss-Pin des integrierten Treiberschaltkreises kontaktiert wird. Der Eingangsanschluss-Pin des integrierten Treiberschaltkreises ist ein - auch nach einem Verpackungsschritt des integrierten Schaltkreises - nach außen geführter Pin, der bei einer Verwendung des integrierten Treiberschaltkreises, beispielsweise auf einer Leiterplatte, mit weiteren Schaltungsteilen, beispielsweise einem Port eines Mikrocontrollers, elektrisch kontaktiert wird. Eine Auswahl der aktiven Spezifikation des integrierten Treiberschaltkreises findet folglich in einem der letzten Herstellungsschritte des integrierten Treiberschaltkreises dadurch statt, dass der dem aktiven Eingangsanschluss zugeordnete Bond-Pad mit einem nach außen geführten Eingangsanschluss-Pin des Schaltkreises kontaktiert oder "gebondet" wird. Bevorzugt ist der Ausgangsanschluss ebenfalls als Bond-Pad ausgeführt, wobei bei dem Verpackungsvorgang des integrierten Treiberschaltkreises der Ausgangsanschluss-Bond-Pad mit einem zugehörigen Ausgangs-Anschluss-Pin des integrierten Treiberschaltkreises kontaktiert wird.

Bevorzugte Ausführungsformen der Erfindung sind in den Zeichnungen dargestellt. Hierbei zeigen schematisch.
- Fig. 1: einen integrierten Treiberschaltkreis für einen LIN-Bus als so genanntes "Die" während eines Bondvorgangs und
- Fig. 2: ein Schaltbild einer Spezifikationsauswahlschaltung und einer Sendeschaltung des integrierten Treiberschaltkreises von Fig. 1.

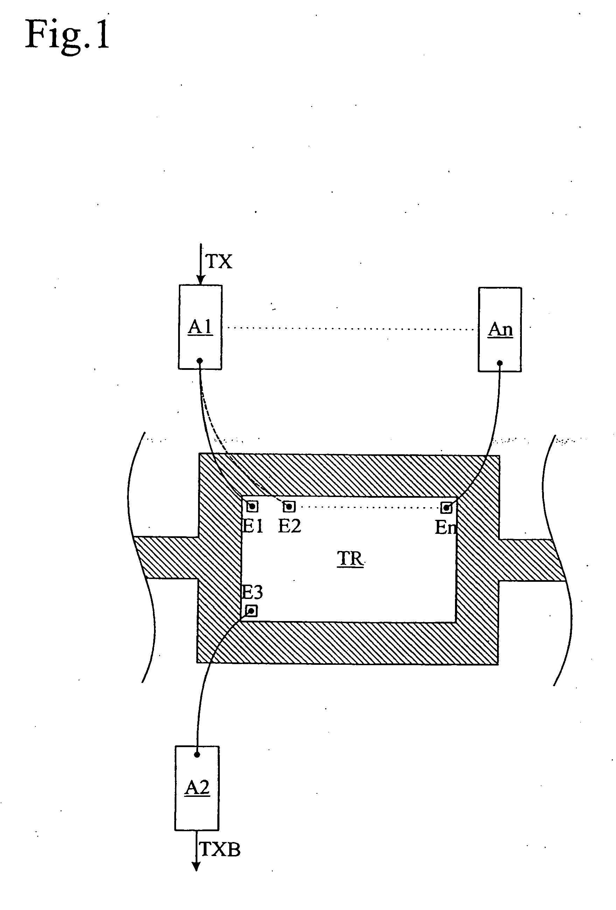

Fig. 1 zeigt einen integrierten Treiberschaltkreis TR für einen LIN-Bus als so genanntes "Die" während eines Bond- oder Verpackungsvorgangs. Der integrierte Treiberschaltkreis TR als "Die" umfasst einen ersten Eingangsanschluss in Form eines ersten Bond-Pads E1 und einen zweiten Eingangsanschluss in Form eines zweiten Bond-Pads E2, wobei ein Eingangsdatensignal TX, welches chipextern erzeugt wird, in Abhängigkeit von einer gewählten Bondvariante oder Bondoption entweder an dem ersten Eingangsanschluss bzw. dem ersten Bond-Pad E1 oder dem zweiten Eingangsanschluss bzw. dem zweite Bond-Pad E2 ansteht.

Die gewählte Bondvariante bestimmt, ob ein nach außen geführter erster Eingangsanschluss-Pin A1 des dann fertig in ein Gehäuse verpackten integrierten Treiberschaltkreises TR mit dem Bond-Pad E1 oder dem Bond-Pad E2 kontaktiert ist.

Ein Ausgangsanschluss in Form eines Bond-Pads E3 ist über eine Bondverbindung mit einem nach außen geführten Ausgangsanschluss-Pin A2 des dann fertig in ein Gehäuse verpackten integrierten Treiberschaltkreises TR kontaktiert. Der Ausgangsanschluss-Pin A2 bzw. mittelbar das Bond-Pad E3 ist im Betrieb des integrierten Treiberschaltkreises TR mit einer nicht gezeigten Busleitung eines LIN-Bussystems verbunden, wobei an dem Ausgangsanschluss-Pin A2 ein von dem Eingangsdatensignal TX abhängiges Ausgangsdatensignal TXB ausgegeben wird.

Der integrierte Treiberschaltkreis TR weist noch weitere, nicht näher spezifizierte exemplarische Bond-Pads En und zugehörige Anschluss-Pins An auf, die übliche Funktionen, beispielsweise einen Empfangspfad und Konfigurationsfunktionen etc., bereitstellen können.

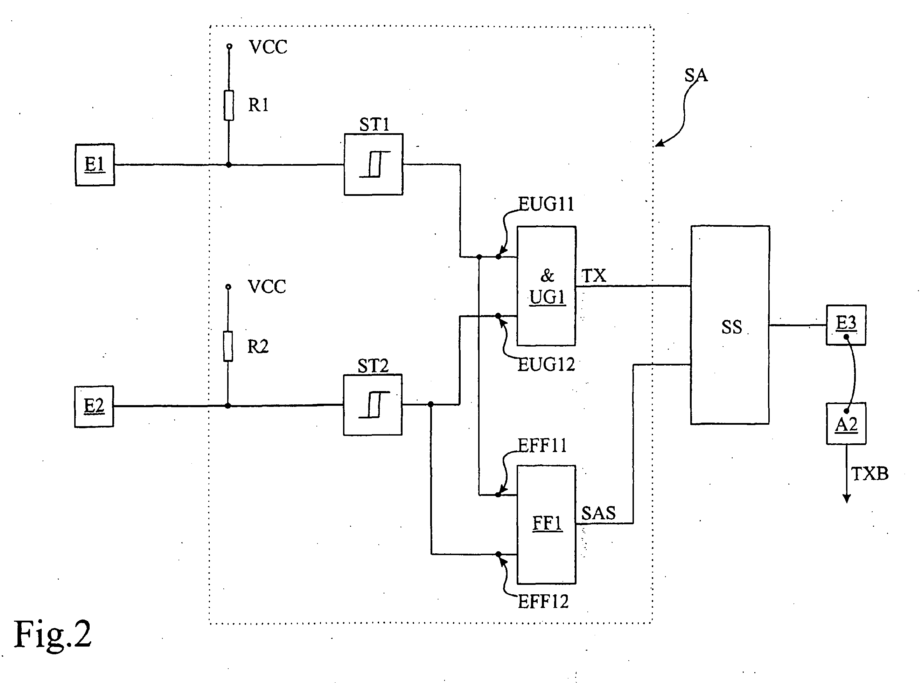

Erfindungsgemäß entscheidet die gewählte Bondvariante der Bond-Pads E1 und E2 zu dem nach außen geführten Eingangsanschluss-Pin A1, nach welcher Lin-Bus-Spezifikation das am Ausgangsanschluss-Pin A2 ausgegebene Ausgangsdatensignal TXB erzeugt wird. Wenn das Bond-Pad E1 mit dem ersten Eingangsanschluss-Pin A1 kontaktiert ist, werden die Ausgangsdatensignale TXB gemäß der Spezifikation V1.3 ausgegeben. Wenn andernfalls das Bond-Pad E2 mit dem ersten Eingangsanschluss-Pin A1 kontaktiert ist, werden die Ausgangsdatensignale TXB gemäß der Spezifikation V2.0 ausgegeben. Die Flankensteilheit gemäß der Spezifikation V2.0 ist größer als die der Spezifikation V1.3. Fig. 2 zeigt ein Schaltbild einer Spezifikationsauswahlschaltung SA und einer Sendeschaltung SS des integrierten Treiberschaltkreises TR von Fig. 1. Die Spezifikationsauswahlschaltung SA ermittelt und speichert an welchem der Eingangsanschlüsse E1 bzw. E2 das aktive Signal TX ansteht und erzeugt ein Spezifikationsauswahlsignal SAS, welches an die Sendeschaltung SS angelegt wird. Die Sendeschaltung SS erzeugt Ausgangsdatensignale TXB gemäß der ersten oder der zweiten Spezifikation in Abhängigkeit von einem Zustand des Spezifikationsauswahlsignals SAS.

Die Spezifikationsauswahlschaltung SA ist mit dem ersten Eingangsanschluss bzw. dem ersten Bond-Pad E1 und dem zweiten Eingangsanschluss bzw. dem zweiten Bond-Pad E2 gekoppelt. Zwischen eine Versorgungsspannung VCC und den Eingangsanschluss E1 ist ein erster Pull-Up-Widerstand R1 eingeschleift und zwischen die Versorgungsspannung VCC und den zweiten Eingangsanschluss E2 ist ein zweiter Pull-Up-Widerstand R2 eingeschleift. Wenn ein Eingangsanschluss E1 bzw. E2 nicht mit dem ersten Eingangsanschluss-Pin A1 kontaktiert ist, wird dieser durch seinen zugehörigen Pull-Up-Widerstand R1 bzw. R2 statisch auf den Versorgungsspannungspegel VCC gezogen.

Das an einem Eingangsanschluss E1 bzw. E2 anstehende Signal TX wird durch einen zugehörigen Schmitt-Trigger ST1 bzw. ST2 aufbereitet und an einen zugehörigen Eingang EUG11 bzw. EUG12 eines UND-Gatters UG1 angelegt. Da ein nicht kontaktierter Eingangsanschluss E1 bzw. E2 statisch auf einem High-Pegel liegt, wird das an dem kontaktierten Eingangsanschluss E1 bzw. E2 anstehende Signal TX unverändert durch das UND-Gatter UG1 an die Sendeschaltung SS ausgegeben, die zwischen den Ausgangsanschluss E3 und den ersten und den zweiten Eingangsanschluss E1 und E2 eingeschleift ist und die das Eingangssignal TX gemäß der mittels des Spezifikationsauswahlsignals SAS eingestellten Spezifikation aufbereitet und als das Ausgangsdatensignal TXB ausgibt.

Die Spezifikationsauswahlschaltung SA umfasst weiterhin ein Flip-Flop FF1, wobei ein erster Flip-Flop-Eingang EFF11 mit dem ersten Eingangsanschluss E1 über den ersten Schmitt-Trigger ST1 verbunden ist und ein zweiter Flip-Flop-Eingang EFF12 mit dem zweiten Eingangsanschluss E2 über den Schmitt-Trigger ST2 verbunden ist. Das Spezifikationsauswahlsignal SAS wird am Ausgang des Flip-Flops FF1 ausgegeben und an die Sendeschaltung SS angelegt. Die Sendeschaltung SS erzeugt in Abhängigkeit von dem Spezifikationsauswahlsignal SAS das Ausgangsdatensignal TXB am Ausgangsanschluss-Pin A2 gemäß der Spezifikation V1.3 oder V2.0.

In einem Anfangzustand des Betriebs des integrierten Treiberschaltkreises TR liegt an beiden Eingängen EFF11 und EFF2 des Flip-Flops FF1 ein High-Pegel an. Das Spezifikationsauswahlsignal SAS wird hierbei mit einem Pegel erzeugt, welcher der Spezifikation V1.3 entspricht.

Wenn der Eingangsanschluss bzw. das Bond-Pad E1 nach außen geführt ist, d.h. mit dem Eingangsanschluss-Pin A1 kontaktiert ist, bleibt das Spezifikationsauswahlsignal SAS unverändert, selbst wenn das am Eingangsanschluss E1 anstehende Signal nach Masse gezogen wird. Das Ausgangsdatensignal TXB wird folglich dauerhaft gemäß der Spezifikation V1.3 erzeugt.

Wenn andernfalls der Eingangsanschluss bzw. das Bond-Pad E2 nach außen geführt ist, d.h. mit dem Eingangsanschluss-Pin A1 kontaktiert ist, kippt das Spezifikationsauswahlsignal SAS auf einen Pegel, der der Spezifikation V2.0 entspricht, sobald das am Eingangsanschluss E2 anstehende Signal nach Masse gezogen wird. Dieser Zustand bleibt durch das Flip-Flop gespeichert, selbst wenn das am Eingangsanschluss E2 anstehende Signal wieder auf den VCC-Pegel zurückgeht. Das Ausgangsdatensignal TXB wird folglich gemäß der Spezifikation V2.0 erzeugt.

Die Auswahl der Spezifikation erfolgt im Betriebsfall des integrierten Treiberschaltkreises TR folglich in einfacher Weise dadurch, dass die Spezifikationsauswahfschaltung SA das Spezifikationsauswahlsignal SAS in Abhängigkeit davon erzeugt, ob das Eingangsdatensignal TX an den ersten Eingangsanschluss E1 oder den mindestens zweiten Eingangsanschluss E2 angelegt ist.

Eine Spezifizierung bzw. eine Typisierung des integrierten Treiberschaltkreises TR erfolgt mittels entsprechender Kontaktierung der Bond-Pads E1 bzw. E2 mit dem Eingangsanschluss-Pin A1 während eines Verpackungs- oder Bondvorgangs.

Es versteht sich, dass eine Umschaltung auch zwischen mehr als zwei Spezifikationen mittels weiterer Eingangsanschlüsse möglich ist. Weiterhin ist die Spezifikationsumschaltung nicht auf die Versionen V1.3 und V2.0 beschränkt, sondern umfasst auch zukünftige Spezifikationen oder Standards oder eine Umschaltung zwischen weiteren Parametern.

Zusammenfassend umfasst der integrierte Treiberschaltkreis TR einen ersten Eingangsanschluss, mindestens einen zweiten Eingangsanschluss und einen Ausgangsanschluss, der mit einer Busleitung des LIN-Bus zu verbinden ist und an dem ein von einem Eingangsdatensignal abhängiges Ausgangsdatensignal ausgegeben wird, wobei das Ausgangsdatensignal gemäß einer ersten oder gemäß mindestens einer zweiten LIN-Bus-Spezifikation in Abhängigkeit davon ausgegeben wird, ob das Eingangsdatensignal an den ersten Eingangsanschluss oder den mindestens zweiten Eingangsanschluss angelegt ist.

## Patentansprüche

1. Integrierter Treiberschaltkreis (TR) für einen LIN-Bus mit
- einem ersten Eingangsanschluss (E1), an den ein Eingangsdatensignal (TX) anlegbar ist,
- einem Ausgangsanschluss (E3, A2), der mit einer Busleitung des LIN-Bus zu verbinden ist und an dem ein von dem Eingangsdatensignal (TX) abhängiges Ausgangsdatensignal (TXB) ausgegeben wird,
**gekennzeichnet durch**
- mindestens einen zweiten Eingangsanschluss (E2), wobei das Eingangsdatensignal (TX) entweder an den ersten Eingangsanschluss (E1) oder den zweiten Eingangsanschluss (E2) anzulegen ist,
- eine Sendeschaltung (SS), die zwischen den Ausgangsanschluss (E3, A2) und den ersten und den zweiten Eingangsanschluss (E1, E2) eingeschleift ist und die aus dem Eingangsdatensignal (TX) das Ausgangsdatensignal (TXB) erzeugt, wobei die Sendeschaltung (SS) in Abhängigkeit von einem Spezifikationsauswahlsignal (SAS) das Ausgangsdatensignal (TXB) gemäß einer ersten Spezifikation oder gemäß mindestens einer zweiten Spezifikation erzeugt, und
- eine mit dem ersten und dem zweiten Eingangsanschluss (E1, E2) und der Sendeschaltung (SS) gekoppelte Spezifikationsauswahlschaltung (SA), die das Spezifikationsauswahlsignal (SAS) in Abhängigkeit davon erzeugt, ob das Eingangsdatensignal (TX) an den ersten Eingangsanschluss (E1) oder den mindestens zweiten Eingangsanschluss (E2) angelegt ist.

2. Integrierter Treiberschaltkreis (TR) nach Anspruch 1, **dadurch gekennzeichnet, dass** Ausgangsdatensignale (TXB), die gemäß der ersten Spezifikation erzeugt werden, eine andere Flankensteilheit aufweisen als Ausgangsdatensignale (TXB), die gemäß der zweiten Spezifikation erzeugt werden.

3. Integrierter Treiberschaltkreis (TR) nach Anspruch 1 oder 2, **dadurch gekennzeichnet, dass** die erste Spezifikation die LIN-Bus-Spezifikation Version 1.3 ist und die zweite Spezifikation die LIN-Bus-Spezifikation Version 2.0 ist.

4. Integrierter Treiberschaltkreis (TR) nach einem der Ansprüche 1 bis 3, **dadurch gekennzeichnet, dass** die Spezifikationsauswahlschaltung (SAS) ein Flip-Flop (FF1) umfasst, wobei ein erster Flip-Flop-Eingangsanschluss (EFF11) mit dem ersten Eingangsanschluss (E1) verbunden ist, ein zweiter Flip-Flop-Eingangsanschluss (EFF12) mit dem zweiten Eingangsanschluss (E2) verbunden ist und an einem Flip-Flop-Ausgangsanschluss das Spezifikationsauswahlsignal (SAS) ansteht.

5. Integrierter Treiberschaltkreis (TR) nach einem der vorhergehenden Ansprüche, **dadurch gekennzeichnet, dass** zwischen den ersten Eingangsanschluss (E1) und eine Versorgungsspannung (VCC) ein erster Pull-Up-Widerstand (R1) eingeschleift ist und zwischen den zweiten Eingangsanschluss (E2) und die Versorgungsspannung (VCC) ein zweiter Pull-Up-Widerstand (R2) eingeschleift ist.

6. Integrierter Treiberschaltkreis (TR) nach einem der vorhergehenden Ansprüche, **dadurch gekennzeichnet, dass** zwischen die Sendeschaltung (SS) und den ersten und zweiten Eingangsanschluss (E1, E2) ein UND-Gatter (UG1) eingeschleift ist, wobei ein erster UND-Gatter-Eingangsanschluss (EUG11) mit dem ersten Eingangsanschluss (E1) verbunden ist, ein zweiter UND-Gatter-Eingangsanschluss (EUG12) mit dem zweiten Eingangsanschluss (E2) verbunden ist und ein UND-Gatter-Ausgangsanschluss mit der Sendeschaltung (SS) verbunden ist.

7. Integrierter Treiberschaltkreis (TR) nach einem der vorhergehenden Ansprüche, **dadurch gekennzeichnet, dass** der erste Eingangsanschluss als ein erster Bond-Pad (E1) ausgeführt ist und der zweite Eingangsanschluss als ein zweiter Bond-Pad (E2) ausgeführt ist, wobei bei einem Verpackungsvorgang des integrierten Treiberschaltkreises (TR) in Abhängigkeit von einer gewünschten Spezifikation entweder der erste Bond-Pad (E1) oder der zweite Bond-Pad (E2) mit einem zugehörigen Eingangsanschluss-Pin (A1) des integrierten Treiberschaltkreises (TR) kontaktiert wird.

8. Integrierter Treiberschaltkreis (TR) nach Anspruch 7, **dadurch gekennzeichnet, dass** der Ausgangsanschluss als Bond-Pad (E3) ausgeführt ist, wobei bei dem Verpackungsvorgang des integrierten Treiberschaltkreises (TR) das Bond-Pad (E3) mit einem zugehörigen Ausgangs-Anschluss-Pin (A2) des integrierten Treiberschaltkreises (TR) kontaktiert wird.

## Claims

1. Integrated driver circuit (TR) for a LIN bus with
- a first input terminal (E1) to which an input data signal (TX) can be applied,
- an output terminal (E3, A2) for connecting to a bus line of the LIN bus and at which an output data signal (TXB) dependent on the input data signal (TX) can be output, **characterised by**
- at least a second input terminal (E2), wherein the input data signal (TX) is applied either to the first input terminal (E1) or to the second input terminal (E2),
- a transmitter circuit (SS), which is looped in between the output terminal (E3, A2) and the first and second input terminal (E1, E2) and which generates the output data signal (TXB) from the input data signal (TX), wherein the transmitter circuit (SS) generates the output data signal (TXB) as a function of a specification selection signal (SAS) on the basis of a first specification or on the basis of at least a second specification, and
- a specification selection circuit (SA) coupled with the first and the second input terminal (E1, E2) and the transmitter circuit (SS), which generates the specification selection signal (SAS) depending on whether the input data signal (TX) is applied to the first input terminal (E1) or the at least second input terminal (E2).

2. Integrated driver circuit (TR) as claimed in claim 1, **characterised in that** the output data signals (TXB) generated on the basis of the first specification have a different flank steepness from output data signals (TXB) generated on the basis of the second specification.

3. Integrated driver circuit (TR) as claimed in claim 1 or 2, **characterised in that** the first specification is the LIN bus specification version 1.3 and the second specification is the LIN bus specification version 2.0.

4. Integrated driver circuit (TR) as claimed in one of claims 1 to 3, **characterised in that** the specification selection circuit (SAS) comprises a flip-flop (FF1), wherein a first flip-flop input terminal (EFF11) is connected to the first input terminal (E1), a second flip-flop input terminal (EFF12) is connected to the second input terminal (E2) and the specification selection signal (SAS) is applied to a flip-flop output terminal.

5. Integrated driver circuit (TR) as claimed in one of the preceding claims, **characterised in that** a first pull-up resistor (R1) is looped in between the first input terminal (E1) and a supply voltage (VCC) and a second pull-up resistor (R2) is looped in between the second input terminal (E2) and the supply voltage (VCC).

6. Integrated driver circuit (TR) as claimed in one of the preceding claims, **characterised in that** an AND gate (UG1) is looped in between the transmitter circuit (SS) and the first and second input terminal (E1, E2), wherein a first AND gate input terminal (EUG11) is connected to the first input terminal (E1), a second AND gate input terminal (EUG12) is connected to the second input terminal (E2) and an AND gate output terminal is connected to the transmitter circuit (SS).

7. Integrated driver circuit (TR) as claimed in one of the preceding claims, **characterised in that** the first input terminal is provided in the form of a first bond pad (E1) and the second input terminal is provided in the form of a second bond pad (E2), wherein during a process of packaging the integrated driver circuit (TR), either the first bond pad (E1) or the second bond pad (E2) is contacted with a co-operating input terminal pin (A1) of the integrated driver circuit (TR) depending on a desired specification.

8. Integrated driver circuit (TR) as claimed in claim 7, **characterised in that** the output terminal is provided in the form of a bond pad (E3), wherein during the process of packaging the integrated driver circuit (TR), the bond pad (E3) is contacted with a co-operating output terminal pin (A2) of the integrated driver circuit (TR).

## Revendications

1. Circuit pilote intégré (TR) pour un bus LIN doté :
- d'un premier raccordement d'entrée (E1) auquel on peut appliquer un signal de données d'entrée (TX),
- d'un raccordement de sortie (E3, A2) qui doit être relié à une ligne de bus du bus LIN et auquel est délivré un signal de données de sortie (TXB) dépendant du signal de données d'entrée (TX) ;
**caractérisé par**
- au moins un deuxième raccordement d'entrée (E2), le signal de données d'entrée (TX) devant être appliqué soit au premier raccordement d'entrée (E1), soit au deuxième raccordement d'entrée (E2),
- un circuit d'émission (SS) qui est monté entre le raccordement de sortie (E3, A2) et le premier et le deuxième raccordement d'entrée (E1, E2) et qui génère le signal de données de sortie (TXB) à partir du signal de données d'entrée (TX), le circuit d'émission (SS) générant le signal de données de sortie (TXB) en fonction d'un signal de sélection de spécification (SAS) selon une première spécification ou selon au moins une deuxième spécification, et
- un circuit de sélection de spécification (SA), qui est couplé au premier et au deuxième raccordement d'entrée (E1, E2) et au circuit d'émission (SS), et qui génère le signal de sélection de spécification (SAS) selon que le signal de données d'entrée (TX) est appliqué au premier raccordement d'entrée (E1) ou au moins au deuxième raccordement d'entrée (E2).

2. Circuit pilote intégré (TR) selon la revendication 1, **caractérisé en ce que** des signaux de données de sortie (TXB), qui sont générés selon la première spécification, présentent une autre pente de signal que les signaux de données de sortie (TXB) qui sont générés selon la deuxième spécification.

3. Circuit pilote intégré (TR) selon la revendication 1 ou 2, **caractérisé en ce que** la première spécification est la version 1.3 de la spécification du bus LIN et **en ce que** la deuxième spécification est la version 2.0 de la spécification du bus LIN.

4. Circuit pilote intégré (TR) selon l'une quelconque des revendications 1 à 3, **caractérisé en ce que** le circuit de sélection de spécification (SAS) comporte une bascule bistable (FF1), un premier raccordement d'entrée de la bascule bistable (EFF11) étant relié au premier raccordement d'entrée (E1), un deuxième raccordement d'entrée de la bascule bistable (EFF12) étant relié au deuxième raccordement d'entrée (E2) et le signal de sélection de spécification (SAS) étant présent en un raccordement de sortie de la bascule bistable.

5. Circuit pilote intégré (TR) selon l'une quelconque des revendications précédentes, **caractérisé en ce qu'**une première résistance de rappel vers le niveau haut (R1) est montée entre le premier raccordement d'entrée (E1) et une tension d'alimentation (VCC) et **en ce qu'**une deuxième résistance de rappel vers le niveau haut (R2) est montée entre le deuxième raccordement d'entrée (E2) et la tension d'alimentation (VCC).

6. Circuit pilote intégré (TR) selon l'une quelconque des revendications précédentes, **caractérisé en ce qu'**une porte ET (UG1) est montée entre le circuit d'émission (SS) et le premier et le deuxième raccordement d'entrée (E1, E2), un premier raccordement d'entrée de porte ET (EUG11) étant relié au premier raccordement d'entrée (E1), un deuxième raccordement d'entrée de porte ET (EUG12) étant relié au deuxième raccordement d'entrée (E2) et un raccordement de sortie de porte ET étant relié au circuit d'émission (SS).

7. Circuit pilote intégré (TR) selon l'une quelconque des revendications précédentes, **caractérisé en ce que** le premier raccordement d'entrée est exécuté sous forme d'un premier plot de connexion (E1) et **en ce que** le deuxième raccordement d'entrée est exécuté sous forme d'un deuxième plot de connexion (E2), lors d'une opération de mise en boîtier du circuit pilote intégré (TR), soit le premier plot de connexion (E1), soit le deuxième plot de connexion (E2) étant mis en contact avec une broche de raccordement d'entrée associée (A1) du circuit pilote intégré (TR) en fonction d'une spécification souhaitée.

8. Circuit pilote intégré (TR) selon la revendication 7, **caractérisé en ce que** le raccordement de sortie est exécuté sous forme d'un plot de connexion (E3), lors de l'opération de mise en boîtier du circuit pilote intégré (TR), le plot de connexion (E3) étant mis en contact avec une broche de raccordement de sortie associée (A2) du circuit pilote intégré (TR).
